# EUROPEAN PATENT APPLICATION

(11) **EP 4 672 006 A1**
(43) Date of publication of application: **31.12.2025**
(21) Application number: 25178533.3
(22) Date of filing: 23.05.2025
(51) Int. Cl.: G06F 13/16, G11C 29/02, G11C 7/04, G11C 5/04, G11C 7/10, G11C 29/04

(54) **DYNAMICALLY INSERT TIMING AND VOLTAGE OFFSET CONTROL (VOC) OFFSETS IN INPUT/OUTPUT (IO) DURING FUNCTIONAL TRAFFIC**

(30) Priority: 26.06.2024 US 202418754699
(71) Applicant: INTEL Corporation, Santa Clara, CA 95054 (US)
(72) Inventor: CHINNAKKONDA VIDYAPOORNACHARY, Diyanesh Babu, Austin (US); ROSE, Tonia M., Wendell (US)
(74) Representative: Rummler, Felix

(57) **Abstract**

A memory subsystem includes a memory space reserved for margining traffic. The memory controller sets a rank bit to select the reserved memory space and configures a physical interface with different settings to test. Thus, the system can have operational IO (input/output) settings and margining IO settings that can both be used at runtime. If the margining IO settings provide an improved error rate over the operational IO settings, the memory controller can reconfigure the operation IO settings.

## Description

### FIELD

Descriptions are generally related to memory systems, and more particular descriptions are related to input/output training.

### BACKGROUND

As the communication speed of memory subsystems increases, the timing margins decrease. The smaller timing margins make the system more susceptible to variations in voltage, temperature, and other factors that can affect signal integrity, increasing the bit error rate. If the actual margins for the TX (transmit) eye and RX (receive) eye are too small, it can lead to data errors and system instability.

The system can monitor the actual margins of the TX/RX eyes during system boot. During normal operation of the memory IO (input/output) interface, the timings for read DQS (data strobe), write DQ (data), and VOC (voltage offset control) fine adjustments are changed dynamically as ranks are switching. The timings and/or voltage can also change due to temperature changes. There is logic to manage the switches in timing because each rank will have different trained values.

Unlike during boot time, a memory system's workloads during functional operation can be highly dynamic. The dynamic memory traffic leads to changes in the system's operating conditions, which can affect the TX/RX eye margins. By monitoring the TX and RX eye margins during functional operation, a system can detect potential stability issues before they lead to system failures. However, when the settings that control the timings are modified during functional traffic, there is a risk of corrupting data for normal operation. To avoid the risk of corrupting the data, the memory controller stalls to measure and adjust the margining for IO interface.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1** is a block diagram of an example of a system for runtime memory IO margining.
**Figure 2** is a block diagram of an example of a system with memory space reserved for margining traffic.
**Figure 3** is a block diagram of an example of an RDIMM system for runtime memory IO margining.
**Figure 4A** is a representation of an example of timing setting variation based on runtime memory IO margining.
**Figure 4B** is a representation of an example of voltage setting variation based on runtime memory IO margining.
**Figure 5** is a flow diagram of an example of a process for applying a reserved memory space for margining traffic.
**Figure 6** is a block diagram of an example of a memory subsystem in which runtime memory IO margining can be implemented.
**Figures 7A-7B** are block diagrams of an example of a CAMM system in which runtime memory IO margining can be implemented.
**Figure 8** is a block diagram of an example of a computing system in which runtime memory IO margining can be implemented.
**Figure 9** is a block diagram of an example of a multi-node network in which runtime memory IO margining can be implemented.

Descriptions of certain details and implementations follow, including non-limiting descriptions of the figures, which may depict some or all examples, and well as other potential implementations.

### DETAILED DESCRIPTION

As described herein, a memory subsystem includes a memory space reserved for margining traffic. The memory controller sets a rank bit to select the reserved memory space and configures a physical interface with different settings to test. Thus, the system can have operational IO (input/output) settings and margining IO settings that can both be used at runtime. Thus, the system can understand the health of the memory IO (input/output) interface without interrupting runtime traffic.

If the margining IO settings provide an improved error rate over the operational IO settings, the memory controller can reconfigure the operation IO settings, instead of changing the interface settings offline in a condition such as boot time. The active runtime memory IO margining of the data bus allows the system to perform runtime monitoring and adjustment of the IO interface.

Thus, during runtime, the system can pinpoint issues that could lead to data errors or system instability. The system can monitor the transmit (TX) eye margin and the receive (RX) eye margin during runtime to fine tune the IO settings, preventing the margins from becoming too small. With access to the reserved memory space with different settings, the system can test and verify the proper IO settings on specific interface without interrupting runtime traffic. Because the settings are configured on the interface at runtime, the settings can be changed dynamically as runtime operating conditions change (e.g., by changes to temperature, voltage, or other conditions). The system can thus detect and respond to changes in realtime.

In one example, the additional rank bit in the hardware interface between the memory controller and the memory IO (e.g., a DDRIO (double data rate 10)) is configurable through MMC (memory microcontroller) firmware, which allows for the application of different timings to data associated with the reserved memory space accessible through the rank bit. In one example, the system applies different VOC (voltage offset control) offsets to data associated with the rank bit. In one example, the system applies different timing settings and different VOC offset settings to data associated with the rank bit.

When the rank bit is set, the memory device writes to and reads from the reserved space, allowing the system to use the specially marked memory location to determine pass/fail for the tested settings. The tested settings refer to the timing offsets/setting, voltage offsets/settings, or both timing and voltage offsets/settings. Determining pass/fail for IO settings enables the system to continuously send margining mixed with normal traffic.

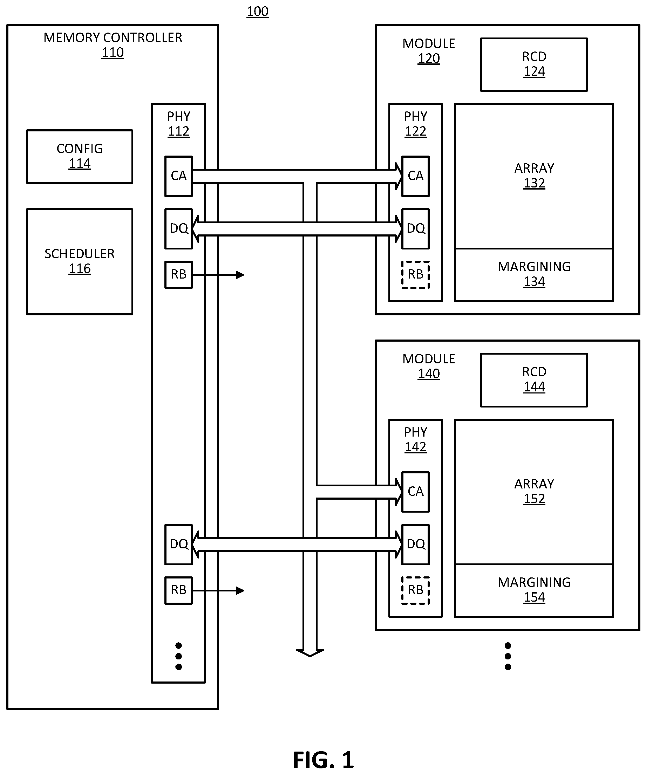

**Figure 1** is a block diagram of an example of a system for runtime memory IO margining. System 100 illustrates memory controller 110 coupled to system memory. Memory controller 110 represents a circuit that manages access to the memory. Memory controller 110 generates and schedules command and address information. Memory controller 110 schedules and provides writes data, as well as receiving read data. Memory controller 110 can be part of a processing unit (e.g., an iMC (integrated memory controller)) or a standalone controller/control circuit.

The system memory of system 100 is represented by module 120 and module 140. In one example, the memory modules are DIMM (dual inline memory module) modules, such as RDIMM modules. In one example, the memory modules are CAMM (compression attached memory module) modules. System 100 can have more than two memory modules. Certain server systems are configured to have 8 or 10 memory modules connected to each processing unit. Other numbers of memory modules are possible.

While not specifically illustrated in system 100, system 100 includes a processor to generate requests for memory access, such as a CPU (central processing unit), GPU (graphics processing unit), or other processor device. The processor device executes programs that generate write requests that trigger write transactions to store data to memory and read requests that trigger read transactions to read data from memory.

Module 120 includes array 132, which represents a memory array to store user data. User data can refer to the data generated by the operation of applications and processes executed by the processing hardware. In one example, module 120 includes margining 134, which represents a reserved memory space for margining data. Similarly, module 140 includes array 152 for user data and margining 154 for margining data.

Memory controller 110 includes PHY (physical interface) 112, which represents the hardware interconnection from the host to the memory. In one example, PHY 112 can be referred to as a DDRIO (double data rate input/output) interface, when DDR memory is attached to the host. The memory similarly includes PHYs, with PHY (physical interface) 122 for module 120 and PHY 142 for module 140. The memory PHYs represents the hardware interconnection from the memory devices to memory controller 110.

The interconnection from the memory devices to the memory controller includes a CA (command/address) bus and a DQ (data) bus. While not specifically illustrated, the interconnection includes CS (chip select) signal lines for individual memory device selection, CK (clock) signal lines, DQS (data strobe) signal lines, and various other signal lines for control and feedback signals.

In one example, the CA bus is connected from PHY 112 to PHY 122 and PHY 142. In one example, each separate memory channel has a separate CA bus. Each module can be part of one or more memory channels. A memory channel refers to a collection of a CA bus and a DQ bus. For a memory module to be part of multiple channels, it will interface with different CA signal lines and DQ signal lines. In the case of a DDR CA bus, two channels can share a single set of CA signal lines, with interleaved CA traffic (e.g., one bus on the rising clock edge, and the other bus on the falling clock edge). As the different memory devices have individual DQ signal lines, each module is illustrated having a different DQ bus connection to memory controller 110.

In one example, PHY 112 includes an RB (rank bit) for each rank of memory. In one example, the rank bit represents a signal line that connects between PHY 112 and PHY 122, and similarly, between PHY 112 and PHY 142. In one example, there is not a physical signal line for the rank bit from the memory controller to the memory devices. Rather, the rank bit can be a control bit with the PHY, controlled by the MMC (memory microcontroller) or other logic of the memory controller. When the rank bit is set internally at the memory controller PHY, PHY 112, it configures the data IO with the margining configuration and writes to and reads from the reserved memory space.

For an example of system 100 where the rank bit is implemented as a separate physical signal line, the dashed RB boxes in PHY 122 and PHY 142 represent the receiving end of the signal at the memory. In an example of system 100 where the rank bit is implemented simply as a control bit in PHY 112, the dashed boxes represent the effect of the margining settings, including the access to margining 134 and margining 154.

While a single rank bit is illustrated, it will be understood that each rank can have a separate rank bit signal line. A memory module can have one or multiple (e.g., 2 or 4) ranks of memory. PHY 112 can be extended in accordance with the number of modules attached, with corresponding CA buses, DQ buses, and rank bits.

In one example, module 120 includes RCD (registering clock driver) 124 and module 140 includes RCD 144. In such a configuration, module 120 and module 140 represent registered modules (e.g., an RDIMM (registered DIMM)). The RCDs are optional, and system 100 can include other circuitry to manage the rank selection that enables access to the reserved space. In one example, module 120 and module 140 represent 3D (three dimensional) stacked memory devices. In one example, RCD 124 receives and responds to the rank bit(s) for module 120. Similarly, RCD 144 can receive and respond to the rank bit(s) for module 140.

The rank bit for module 120 allows for the change in offset only for data associated with data designated for margining 134. The rank bit for module 140 allows for the change in offset only for data associated with data designated for margining 154. In one example, margining 134 and margining 154 are part of a functional memory map maintained by memory controller 110 or other portion of the host. The host reserves the margining portion for the purpose of margining testing.

Memory controller 110 includes scheduler 116 to schedule traffic to memory. In one example, scheduler 116 can mix operational data traffic (e.g., user data) and margining data traffic (e.g., data related to margining testing for the reserved space in memory). The ability to interleave operational traffic and margining traffic enables system 100 to perform IO margining during runtime without interrupting operational memory access.

Margining as used herein refers to the transmission of test traffic (e.g., known data patterns). Margining traffic can refer to the data traffic sent over the DQ bus. The test traffic can be written to the reserved space in memory and read back to measure the data eye on the bus. The data eye measurements are affected by the IO configuration. Margining can include sending different IO configurations than the current configuration to test for an improved IO configuration.

The exchange of the margining traffic is controlled by the rank bit, and more specifically, setting the rank bit in the memory controller PHY can control the setting of the margining IO configuration and the sending of margining traffic to test the margining configuration. In one example, every rank can have its own configuration. Every rank can have its own rank bit to manage the configuration for the rank, changing between the margining configuration for the rank and the functional configuration for the rank.

In one example, system 100 is capable of on-the-fly configuration changes, where the PHY can switch between the functional IO configuration and the margining IO configuration at runtime. The scheduler can mix margining traffic and functional traffic in the schedule to send, and the PHY is configured on the fly for the configuration that matches the type of traffic to send.

With the ability to schedule both functional and margining traffic, scheduler 116 can provide full flexibility of data patterns for testing the IO settings. Again, the system can perform the monitoring and testing without interrupting runtime data operation. The scheduler can simply see the margining traffic as another memory transaction to execute.

Config (configuration) 114 in memory controller 110 represents configuration for the various hardware interfaces of PHY 112. The ability to perform runtime margining allows memory controller 110 to IO settings related to signal timing, voltage (e.g., VOC), or a combination of timing and voltage while the memory controller continues to function normally for system applications. In one example, the margining appears as a special application executed by the system, allowing memory controller 110 to test various settings to the point of failure without interrupting the function of the other applications. The ability to change runtime settings for testing allows system 100 to fine tune the IO settings and coordinate the delta that should be applied for margining testing, mask testing, or both margining testing and mask testing.

The realtime monitoring (RTM) of a system in accordance with system 100 enables system designers to monitor TX/RX eye margins in realtime during functional operation, ensuring reliable performance under changing conditions. The RTM operation allows the system to respond to changes instantly and can maintain system stability without large overhead switching between "ownership" of the bus between the memory controller and the DDRIO subsystem, allowing the system to handle the margin traffic along with the normal functional traffic in the DDRIO.

A system in accordance with system 100 facilitates non-disruptive operation by enabling continuous margining integrated with regular traffic via the memory controller, ensuring uninterrupted system functionality crucial for system operations. Such a system is particularly suitable for servers and is applicable across other computing system applications that use an external memory interface.

A system in accordance with system 100 can reduce system downtime. Through periodic monitoring of the TX/RX eye margins, the system can detect and address data errors and pinpoint system tuning inadequacies or issues with memory modules or the memory controller. Thus, the system can enable prompt and efficient troubleshooting in a preemptive manner before a system failure.

In one example, system 100 includes a rank of memory organized on module 120 or on a combination of module 120 and module 140. The rank includes multiple DRAM (dynamic random access memory) devices. In accordance with what is described above, the IO interface of PHY 112 is selectable between a runtime IO configuration and a margining IO configuration, where selection of the rank bit triggers access to the reserved memory and the application of the margining IO configuration. When the rank bit is not selected, the runtime IO configuration can be applied to the IO interface and data access occurs to the user data portion of the memory array.

In one example, the margining IO configuration has at least one setting different from the runtime IO configuration related to timing or timing delays. Thus, different configurations can have different delay timing. In one example, the margining IO configuration has at least one setting different from the runtime IO configuration related to voltage or voltage offset. In one example, the margining IO configuration has at least one setting different from the runtime IO configuration related to timing or timing delays and at least one setting related to voltage or voltage offset.

In one example, system 100 has multiple ranks of memory, where each rank has multiple DRAM devices. Where there are multiple ranks, the IO interface can be configured differently per rank, where each rank IO interface can have selectable configuration settings and a rank bit to select between functional traffic and margining traffic.

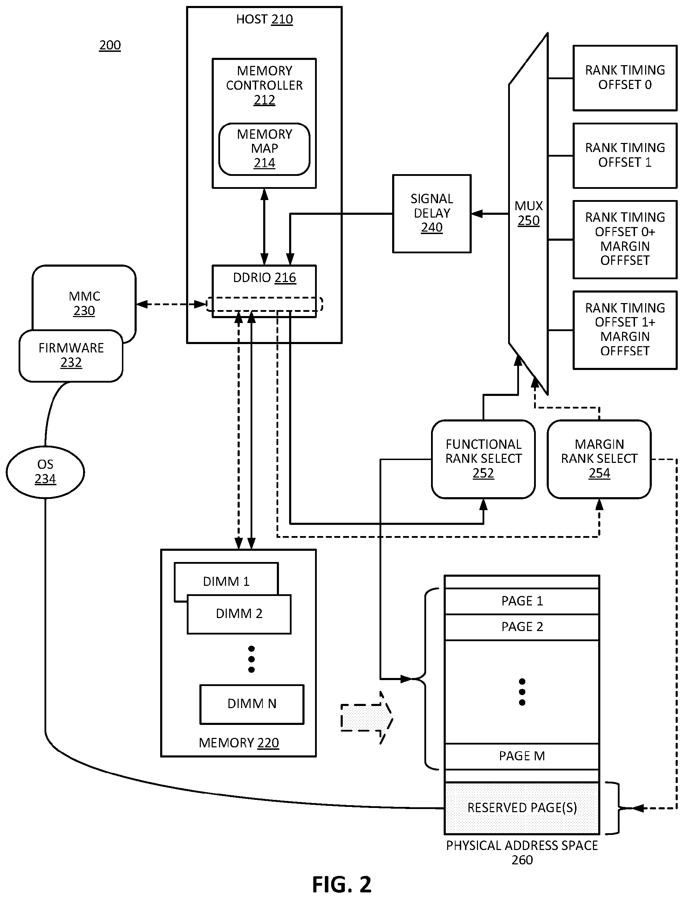

**Figure 2** is a block diagram of an example of a system with memory space reserved for margining traffic. System 200 represents a memory subsystem in accordance with an example of system 100.

Host 210 represents a host hardware platform, including the host processor (not explicitly illustrated), memory controller 212, and DDRIO 216. In one example, memory controller 212 includes memory map 214 to map the memory address space available in memory 220.

Host 210 is coupled to memory 220, which represents the system memory. Memory 220 is illustrated with N memory modules, represented by DIMM 1, DIMM 2, ..., DIMM N. N can be any integer. Other types of memory modules can be used. Memory 220 illustrates a block diagram of the memory hardware.

The address space of memory 220 can be represented by physical address space 260, which is a logical representation of the memory. Physical address space 260 is illustrated with M pages of memory, Page 1, Page 2, ..., Page M. In one example, M=N, and there is a page of memory per memory module. In addition to the M pages of memory, physical address space 260 includes one or more reserved pages of memory to be used for margining traffic.

In system 200, the solid lines represent the operation of the system for functional traffic, while the dashed lines represent the operation of the system for margining traffic. DDRIO 216 couples to memory 220 for both functional traffic and for margining traffic.

For functional traffic, DDRIO 216 selects functional rank select 252, which deselects the rank bit (e.g., logic low for high assertion or logic high for inverted assertion). With the functional rank selection, mux 250 can select between rank timing offset 0 and rank timing offset 1, depending on the rank selection. It will be understood that more ranks can involve more complex rank timing offset selections. Mux 250 provides the selected rank timing offset to signal delay hardware 240, which configures DDRIO 216 for operation with the selected timing offset settings. With the functional rank selection, the portion of physical address space 260 to be accessed is Page 1, ..., Page M.

For margin traffic, DDRIO 216 selects margin rank select 254, which selects the rank bit (e.g., logic high for high assertion or logic low for inverted assertion). With the margining rank selection, mux 250 can select between rank timing offset 0 + margin offset and rank timing offset 1 + margin offset, depending on the rank selection. It will be understood that more ranks can involve more complex rank timing offset selections. Mux 250 provides the selected rank timing offset to signal delay hardware 240, which configures DDRIO 216 for operation with the selected timing offset settings. With the margin rank selection, the portion of physical address space 260 to be accessed is the reserved page(s).

For purposes of illustration in system 200, the rank selection, mux 250, and signal delay 240 are illustrated outside of host 210. In one example, these components are implemented in hardware of DDRIO 216. While timing controls are specifically illustrated, it will be understood that the same operation can occur with Vref (voltage reference) offsets.

Mux 250 can operate to switch the timing for the different ranks the system applications access different portions of memory. In one example, the reserved space is the upper address range of memory map 214. Thus, memory map 214 can allocate all lower addresses for applications executed by host 210 and will reserve the upper ranges for margin traffic as managed by the rank bit(s). In one example, memory map 214 reserves the space for execution of the margining application.

In one example, system 200 includes MMC (memory microcontroller) 230, which represents a controller for DDRIO 216. MMC 230 is typically external to DDRIO 216 and controls the operation of the IO interface. MMC 230 can execute firmware 232 to control the operation of the IO interface. As illustrated, DDRIO 216 can set or unset the additional rank bit, which operates to apply to timings and/or voltage settings for the IO interface. In one example, DDRIO 216 sets and unsets the rank bit based on firmware programming from the MMC.

In one example, firmware 232 enables DDRIO 216 to interface with the host operating system (OS), represented by OS 234. In one example, the application using the memory location for a data checking space can determine pass/fail for the test offsets. The determination of passing and failing can be performed by system 100 writing a known pattern to the memory space and then reading it back. If the pattern read back matches the pattern written, the test is a pass. If the pattern read back does not match, the test is a fail.

In one example, MMC 230 continuously monitors the actual margins of the TX/RX eyes during functional operation. MMC 230 can also test the margining traffic to determine if other settings perform better for current operating conditions of system 200. In one example, if the test traffic results in better error rates than the functional settings, MMC 230 can trigger DDRIO 216 to adjust settings related to timing, VOC, or both timing and VOC to address the point of failure detected in the functional operation.

In one example, MMC 230, through firmware 232 can coordinate with OS applications of OS 234. Coordination with the OS applications can ensure that the memory spaces with the additional rank bit set are not used for normal operation. In one example, memory controller 212 and/or MMC 230 can make OS 234 aware of memory map 214 to ensure the OS knows of the reserved memory space(s) to prevent the OS from allocating the memory for functional use.

In one example, the connection between firmware 232 and OS 234 provides a communication path that can be used to gather and apply telemetry. Gathering telemetry refers to gathering measurement data about the test traffic. Application of the telemetry can refer to post measurement processing performed to determine the response to margin changes. In one example, firmware 232 can receive the margin results. In one example, OS 234 can receive the margin results. In one example, the connection enables system 200 to perform synchronization in memory usage based on observed failures.

In one example, MMC 230 is the final arbiter of the IO settings. Thus, MMC 230 can perform the post measurement processing. In a system that does not include an MMC, the memory controller or some other hardware in the memory subsystem can perform the processing.

The system can observe a BER (bit error rate) for a rank or for a memory channel and determine that the BER has reached an unacceptable level. In one example, the system can turn off the channel and apply the margining with the reserved space to reconfigure the functional IO settings. In one example, based on the BER, the system can spare the channel. It can be understood that performing operations with the margining traffic to make runtime adjustments to the functional IO settings can cause some interruption in the memory bandwidth performance. However, the small interruption can be balanced out by the runtime adjustment of the settings, preventing a reboot of the memory. In one example, based on a BER or a low margin, the system can determine to drop a communication speed of the memory IO channel.

In one example, based on a high BER for runtime traffic, the memory controller can reduce the transfer speed for the runtime traffic, to allow more bandwidth to send margining traffic. In one example, based on a high BER for the runtime traffic, the memory controller can turn off the runtime traffic for a memory channel to allow all memory bandwidth to be used for margining traffic. The margining traffic allows the system to determine an improved IO configuration for the bus, which the system can then apply and restore the runtime traffic on the channel, either returning to a prior transfer speed in the case of a channel where the speed was lowered, or again sending runtime traffic for a channel where the traffic was turned off. An improved IO configuration results in a lower bit error rate for runtime traffic on the channel.

In one example, OS 234 generates the test traffic for use with the margining. In one example, memory controller 212 includes logic to generate the test data patterns. Then, the memory controller would simply need to schedule the margin traffic without needing the OS to generate the traffic.

While illustrated in memory controller 212, in one example, MMC 230 can have a memory map (also referred to as a memory address map) for the physical address space. In one example, system 200 includes an additional indicator for the memory map location with the additional rank bit. The indicator can identify the memory spaces where the additional rank bit is set. Such an indicator can ensure that the reserved space is correctly identified and used. The indicator would help distinguish the reserved space from the rest of the memory map, thus reducing the risk of data corruption during the adjustment of timings.

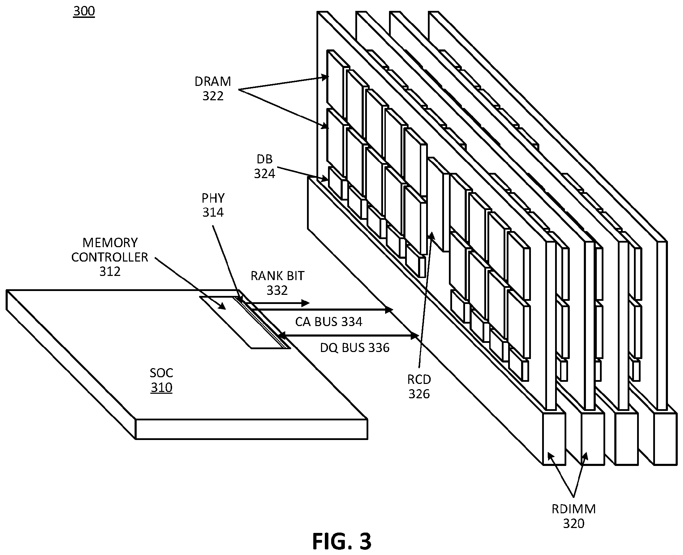

**Figure 3** is a block diagram of an example of an RDIMM system for runtime memory IO margining. System 300 represents an RDIMM (registered dual inline memory module) system in accordance with an example of system 100 or system 200. System 300 includes multiple RDIMMs 320 coupled to memory controller 312 of SOC (system on a chip) 310.

SOC 310 represents a host system including a processor. SOC 310 includes memory controller 312, which can be a circuit integrated on the processor. Memory controller 312 includes PHY 314 in accordance with any example described. RDIMMs 320 represent DIMM modules having multiple DRAMs 322 organized as ranks of memory. In one example, RDIMMs 320 have DBs (data buffers) 324 to buffer the data bus signals between the DRAMs and the memory controller. RDIMMs 320 include RCD (registering clock driver) 326.

RDIMMs 320 represent multiple memory modules having multiple DRAM devices organized as multiple ranks of memory. It is common for RDIMMs to have a first rank and a second rank. Other RDIMM configurations can have the DRAMs organized as four ranks of memory.

PHY 314 includes hardware interfaces to data bus 336, among other signal lines between the memory controller and the memory. PHY 314 includes hardware interface to CA bus 334. As described herein, PHY 314 includes rank bits 332, which represents rank bit signals for the various ranks of memory of RDIMMs 320. In one example, the rank bit signals are implemented only as control signals on the memory controller PHY side, without a signal line to the memory. In one example, rank bits 332 are included in CA bus 334, if the rank bit is implemented as a separate signal line. In one example, the rank bit is implemented as a signal line separate from the DQ bus and separate from the CA bus.

In accordance with any example herein, memory controller 312 can perform margining during runtime through configuration selection with the rank bit. By changing the configuration of PHY 314 and asserting rank bit 332 to trigger access to the reserved memory space, memory controller 312 can write test traffic to the reserved memory space and determine during runtime whether there is PHY configuration that provides an improved data error rate.

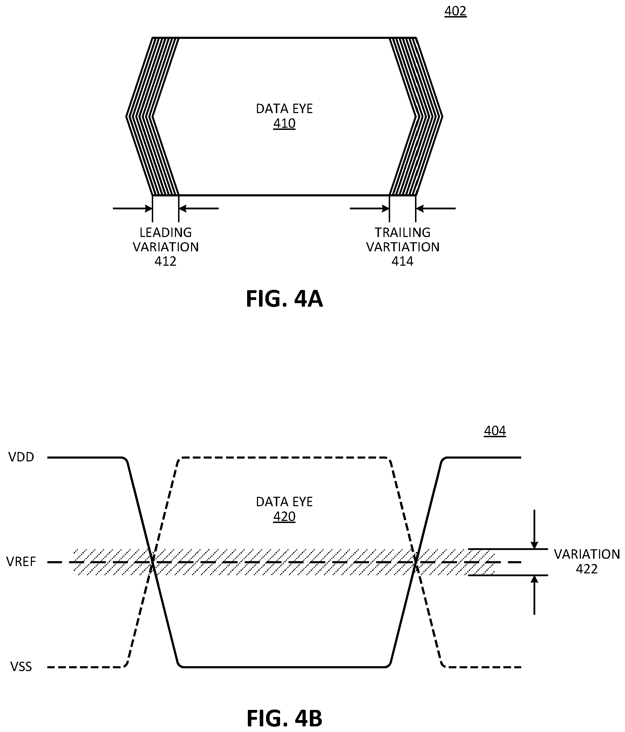

**Figure 4A** is a representation of an example of timing setting variation based on runtime memory IO margining. Diagram 402 illustrates a data eye with adjusted timing margins based on operation of a system in accordance with an example of system 100 or an example of system 200 or an example of system 300.

Diagram 402 illustrates data eye 410, which represents the area between the cumulative sending of logic one and logic zero signals. The area is the space between the cumulative signaling, including an eye height (distance between signal min and max) and an eye width (distance between signal leading edge and signal trailing edge).

As illustrated in diagram 402, the timing settings can change a configuration of the leading edge, illustrated by leading variation 412, a configuration of the trailing edge, illustrated by trailing variation 414, or a combination of the leading edge and the trailing edge. The leading edge refers to the leading rising edge for signals driven to a logic high and the leading falling edge for signals driven to a logic low. The trailing edge refers to the trailing falling edge for signals driven to a logic high and the trailing rising edge for signals driven to a logic low.

In one example, the system performs margining testing to determine the setting for the leading edge and the setting for the trailing edge that results in the lowest bit error rate. In one example, the testing can include sweeping or schmooing the setting to test different settings, which could result in increased signal error. Sweeping different values can enable the system to determine settings that result in the best operation for the current system conditions.

**Figure 4B** is a representation of an example of voltage setting variation based on runtime memory IO margining. Diagram 404 illustrates a data eye with voltage offset based on operation of a system in accordance with an example of system 100 or an example of system 200 or an example of system 300.

Diagram 404 illustrates data eye 420, which represents the area between the cumulative sending of logic one and logic zero signals. The area is the space between the cumulative signaling, including an eye height (distance between signal min and max) and an eye width (distance between signal leading edge and signal trailing edge).

As illustrated in diagram 404, data eye 420 varies between a maximum of VDD and a minimum of VSS, with a reference voltage of VREF between the min and max. If VREF drifts upward, the eye will be constrained on the upper portion of the data eye. If VREF drifts downward, the eye will be constrained on the lower portion of the data eye. Variation 422 represents the range of VOC that can be used to set VREF.

In one example, the system performs margining testing to determine the setting for the voltage offset that results in the lowest bit error rate. In one example, the testing can include sweeping or schmooing the setting to test different settings, which could result in increased signal error. Sweeping different values can enable the system to determine settings that result in the best operation for the current system conditions.

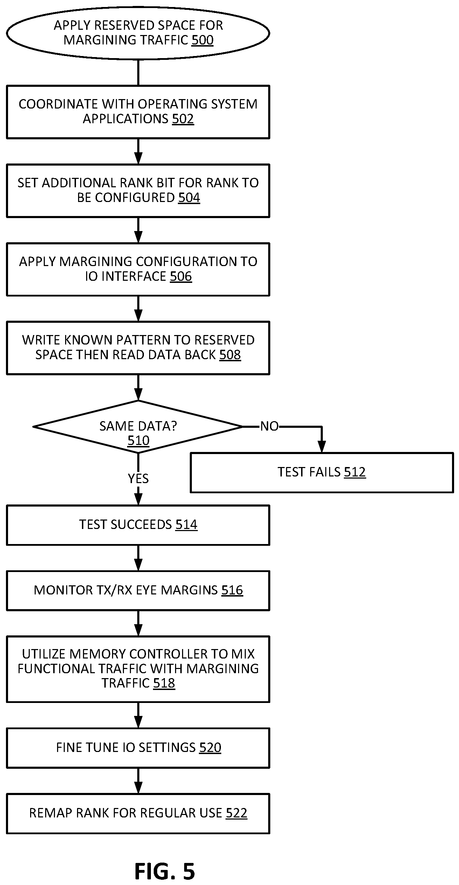

**Figure 5** is a flow diagram of an example of a process for applying a reserved memory space for margining traffic. Process 500 represents a process for applying a reserved memory space for margining traffic. The process involves the adjusting of settings for the timings and/or voltage to the point of failure while ensuring the memory controller continues to function normally for other applications.

In one example, the memory control (e.g., an MMC or memory controller) coordinates with the OS applications, at 502. The coordination can make the OS applications aware of the memory spaces where the additional rank bit is set. The spaces are not used for normal operation, ensuring they are not allocated for common use with functional traffic.

In one example, the IO interface sets an additional rank bit for the rank to be configured for test settings, at 504. Setting the additional rank bit allows for the application of an additional offset to timings and/or voltage. In one example, the adjustment is based on firmware programming from the MMC.

The IO interface can apply the margining configuration to the IO interface, at 506. With the new IO settings, the memory controller can write and read a known data pattern, at 508. The controller can write the known pattern to the memory space where the additional rank bit is set, which is a reserved space used for data checking. The memory controller can then issue commands to read the data back. If the pattern read back does not match the pattern written, at 510 NO branch, the test fails, at 512. If the pattern read back matches the pattern written, at 510 YES branch, the test is considered a pass, at 514.

The MMC can monitor the TX/RX eyes margins, at 516. In one example, the actual margins of the TX/RX eyes are continuously monitored during functional operation. The MMC adjusts the timing and/or voltage to the point of failure as needed. In one example, the system utilizes the memory controller to mix functional traffic with margining traffic, at 518. The continuous utilization of the memory controller during the margining allows the mix of functional traffic and margining traffic without interrupting the operation for user data applications.

The margining allows the system to fine tune the memory IO interface settings, at 520. The fine tuning can include comparing the performance of the margining IO configuration with the runtime configuration to determine which performs better. The culmination of the process allows for the fine tuning of the IO interface settings and facilitates the coordination of the delta that should be applied for margining and/or mask test through margin offsets. In one example, the memory controller remaps the rank for regular use, at 522. Once rank margining is complete, the system can remap the rank for regular workload use, transitioning from margin rank to functional rank.

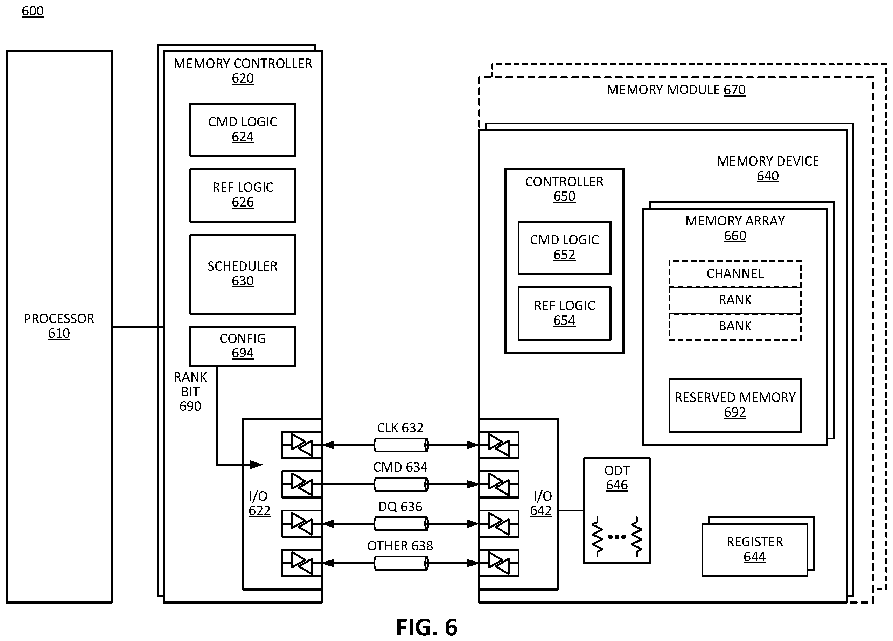

**Figure 6** is a block diagram of an example of a memory subsystem in which runtime memory IO margining can be implemented. System 600 includes a processor and elements of a memory subsystem in a computing device.

System 600 represents a system with a memory subsystem in accordance with an example of system 100 or an example of system 200. In one example, the memory channel IO for memory controller 620 includes rank bit 690 to selectively control the passing of operational traffic and margining traffic on the data bus. In one example, system 600 includes reserved memory 692 in memory device 640. Reserved memory 692 represents a reserved memory space for margining data. Memory controller 620 can include configuration (config 694) to select between functional IO configuration settings and margining IO configuration settings. System 600 can perform runtime IO margining for timing settings, voltage settings, or both timing and voltage settings, in accordance with any example herein.

Processor 610 represents a processing unit of a computing platform that may execute an operating system (OS) and applications, which can collectively be referred to as the host or the user of the memory. The OS and applications execute operations that result in memory accesses. Processor 610 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory accesses may also be initiated by devices such as a network controller or hard disk controller. Such devices can be integrated with the processor in some systems or attached to the processer via a bus (e.g., PCI express), or a combination. System 600 can be implemented as an SOC (system on a chip), or be implemented with standalone components.

Reference to memory devices can apply to different memory types. Memory devices often refers to volatile memory technologies. Volatile memory is memory whose state (and therefore the data stored on it) is indeterminate if power is interrupted to the device. Nonvolatile memory refers to memory whose state is determinate even if power is interrupted to the device. Dynamic volatile memory requires refreshing the data stored in the device to maintain state. One example of dynamic volatile memory includes DRAM (dynamic random-access memory), or some variant such as synchronous DRAM (SDRAM). A memory subsystem as described herein may be compatible with a number of memory technologies, such as DDR5 (double data rate version 5, originally published by JEDEC in July 2020), LPDDR5 (low power DDR version 5, JESD209-5, originally published by JEDEC in February 2019), HBM2 (high bandwidth memory version 2, JESD235C, originally published by JEDEC in January 2020), HBM3 (HBM version 3, JESD238, originally published by JEDEC in January 2022), DDR6 (DDR version 6, in discussion), GDDR7 (graphics DDR version 6, in discussion), or others or combinations of memory technologies, and technologies based on derivatives or extensions of such specifications.

Memory controller 620 represents one or more memory controller circuits or devices for system 600. In one example, memory controller 620 is on the same semiconductor substrate as processor 610. Memory controller 620 represents control logic that generates memory access commands in response to the execution of operations by processor 610. Memory controller 620 accesses one or more memory devices 640. Memory devices 640 can be DRAM devices in accordance with any referred to above. In one example, memory devices 640 are organized and managed as different channels, where each channel couples to buses and signal lines that couple to multiple memory devices in parallel. Each channel is independently operable. Thus, each channel is independently accessed and controlled, and the timing, data transfer, command and address exchanges, and other operations are separate for each channel. Coupling can refer to an electrical coupling, communicative coupling, physical coupling, or a combination of these. Physical coupling can include direct contact. Electrical coupling includes an interface or interconnection that allows electrical flow between components, or allows signaling between components, or both. Communicative coupling includes connections, including wired or wireless, that enable components to exchange data.

In one example, settings for each channel are controlled by separate mode registers or other register settings. In one example, each memory controller 620 manages a separate memory channel, although system 600 can be configured to have multiple channels managed by a single controller, or to have multiple controllers on a single channel. In one example, memory controller 620 is part of host processor 610, such as logic implemented on the same die or implemented in the same package space as the processor.

Memory controller 620 includes I/O interface logic 622 to couple to a memory bus, such as a memory channel as referred to above. I/O interface logic 622 (as well as I/O interface logic 642 of memory device 640) can include pins, pads, connectors, signal lines, traces, or wires, or other hardware to connect the devices, or a combination of these. I/O interface logic 622 can include a hardware interface. As illustrated, I/O interface logic 622 includes at least drivers/transceivers for signal lines. Commonly, wires within an integrated circuit interface couple with a pad, pin, or connector to interface signal lines or traces or other wires between devices. I/O interface logic 622 can include drivers, receivers, transceivers, or termination, or other circuitry or combinations of circuitry to exchange signals on the signal lines between the devices. The exchange of signals includes at least one of transmit or receive. While shown as coupling I/O 622 from memory controller 620 to I/O 642 of memory device 640, it will be understood that in an implementation of system 600 where groups of memory devices 640 are accessed in parallel, multiple memory devices can include I/O interfaces to the same interface of memory controller 620. In an implementation of system 600 including one or more memory modules 670, I/O 642 can include interface hardware of the memory module in addition to interface hardware on the memory device itself. Other memory controllers 620 will include separate interfaces to other memory devices 640.

The bus between memory controller 620 and memory devices 640 can be implemented as multiple signal lines coupling memory controller 620 to memory devices 640. The bus may typically include at least clock (CLK) 632, command/address (CMD) 634, data (DQ) 636, and zero or more other signal lines 638. In one example, a bus or connection between memory controller 620 and memory can be referred to as a memory bus. In one example, the memory bus is a multi-drop bus. The signal lines for CMD can be referred to as a "CA bus" (or ADD/CMD bus, or some other designation indicating the transfer of commands (C or CMD) and address (A or ADD) information) and the signal lines for write and read DQ can be referred to as a "data bus." In one example, independent channels have different clock signals, CA buses, data buses, and other signal lines. Thus, system 600 can be considered to have multiple "buses," in the sense that an independent interface path can be considered a separate bus. It will be understood that in addition to the lines explicitly shown, a bus can include at least one of strobe signaling lines, alert lines, auxiliary lines, or other signal lines, or a combination. It will also be understood that serial bus technologies can be used for the connection between memory controller 620 and memory devices 640. An example of a serial bus technology is 8B10B encoding and transmission of high-speed data with embedded clock over a single differential pair of signals in each direction. In one example, CMD 634 represents signal lines shared in parallel with multiple memory devices. In one example, multiple memory devices share encoding command signal lines of CMD 634, and each has a separate chip select (CS_n) signal line to select individual memory devices.

It will be understood that in the example of system 600, the bus between memory controller 620 and memory devices 640 includes a subsidiary command bus CMD 634 and a subsidiary bus to carry the write and read data, DQ 636. In one example, the data bus can include bidirectional lines for read data and for write/command data. In another example, the subsidiary bus DQ 636 can include unidirectional write signal lines for write and data from the host to memory, and can include unidirectional lines for read data from the memory to the host. In accordance with the chosen memory technology and system design, other signals 638 may accompany a bus or sub bus, such as strobe lines DQS. Based on design of system 600, or implementation if a design supports multiple implementations, the data bus can have more or less bandwidth per memory device 640. For example, the data bus can support memory devices that have either a x4 interface, a x8 interface, a x16 interface, or other interface. The convention "xW," where W is an integer that refers to an interface size or width of the interface of memory device 640, which represents a number of signal lines to exchange data with memory controller 620. The interface size of the memory devices is a controlling factor on how many memory devices can be used concurrently per channel in system 600 or coupled in parallel to the same signal lines. In one example, high bandwidth memory devices, wide interface devices, or stacked memory configurations, or combinations, can enable wider interfaces, such as a x128 interface, a x256 interface, a x512 interface, a x1024 interface, or other data bus interface width.

In one example, memory devices 640 and memory controller 620 exchange data over the data bus in a burst, or a sequence of consecutive data transfers. The burst corresponds to a number of transfer cycles, which is related to a bus frequency. In one example, the transfer cycle can be a whole clock cycle for transfers occurring on a same clock or strobe signal edge (e.g., on the rising edge). In one example, every clock cycle, referring to a cycle of the system clock, is separated into multiple unit intervals (Uls), where each UI is a transfer cycle. For example, double data rate transfers trigger on both edges of the clock signal (e.g., rising and falling). A burst can last for a configured number of Uls, which can be a configuration stored in a register, or triggered on the fly. For example, a sequence of eight consecutive transfer periods can be considered a burst length eight (BL8), and each memory device 640 can transfer data on each UI. Thus, a x8 memory device operating on BL8 can transfer 64 bits of data (8 data signal lines times 8 data bits transferred per line over the burst). It will be understood that this simple example is merely an illustration and is not limiting.

Memory devices 640 represent memory resources for system 600. In one example, each memory device 640 is a separate memory die. In one example, each memory device 640 can interface with multiple (e.g., 2) channels per device or die. Each memory device 640 includes I/O interface logic 642, which has a bandwidth determined by the implementation of the device (e.g., x16 or x8 or some other interface bandwidth). I/O interface logic 642 enables the memory devices to interface with memory controller 620. I/O interface logic 642 can include a hardware interface, and can be in accordance with I/O 622 of memory controller, but at the memory device end. In one example, multiple memory devices 640 are connected in parallel to the same command and data buses. In another example, multiple memory devices 640 are connected in parallel to the same command bus, and are connected to different data buses. For example, system 600 can be configured with multiple memory devices 640 coupled in parallel, with each memory device responding to a command, and accessing memory resources 660 internal to each. For a Write operation, an individual memory device 640 can write a portion of the overall data word, and for a Read operation, an individual memory device 640 can fetch a portion of the overall data word. The remaining bits of the word will be provided or received by other memory devices in parallel.

In one example, memory devices 640 are disposed directly on a motherboard or host system platform (e.g., a PCB (printed circuit board) or substrate on which processor 610 is disposed) of a computing device. In one example, memory devices 640 can be organized into memory modules 670. In one example, memory modules 670 represent dual inline memory modules (DIMMs). In one example, memory modules 670 represent other organization of multiple memory devices to share at least a portion of access or control circuitry, which can be a separate circuit, a separate device, or a separate board from the host system platform. Memory modules 670 can include multiple memory devices 640, and the memory modules can include support for multiple separate channels to the included memory devices disposed on them. In another example, memory devices 640 may be incorporated into the same package as memory controller 620, such as by techniques such as multi-chip-module (MCM), package-on-package, through-silicon via (TSV), or other techniques or combinations. Similarly, in one example, multiple memory devices 640 may be incorporated into memory modules 670, which themselves may be incorporated into the same package as memory controller 620. It will be appreciated that for these and other implementations, memory controller 620 may be part of host processor 610.

Memory devices 640 each include one or more memory arrays 660. Memory array 660 represents addressable memory locations or storage locations for data. Typically, memory array 660 is managed as rows of data, accessed via wordline (rows) and bitline (individual bits within a row) control. Memory array 660 can be organized as separate channels, ranks, and banks of memory. Channels may refer to independent control paths to storage locations within memory devices 640. Ranks may refer to common locations across multiple memory devices (e.g., same row addresses within different devices) in parallel. Banks may refer to sub-arrays of memory locations within a memory device 640. In one example, banks of memory are divided into sub-banks with at least a portion of shared circuitry (e.g., drivers, signal lines, control logic) for the sub-banks, allowing separate addressing and access. It will be understood that channels, ranks, banks, sub-banks, bank groups, or other organizations of the memory locations, and combinations of the organizations, can overlap in their application to physical resources. For example, the same physical memory locations can be accessed over a specific channel as a specific bank, which can also belong to a rank. Thus, the organization of memory resources will be understood in an inclusive, rather than exclusive, manner.

In one example, memory devices 640 include one or more registers 644. Register 644 represents one or more storage devices or storage locations that provide configuration or settings for the operation of the memory device. In one example, register 644 can provide a storage location for memory device 640 to store data for access by memory controller 620 as part of a control or management operation. In one example, register 644 includes one or more Mode Registers. In one example, register 644 includes one or more multipurpose registers. The configuration of locations within register 644 can configure memory device 640 to operate in different "modes," where command information can trigger different operations within memory device 640 based on the mode. Additionally or in the alternative, different modes can also trigger different operation from address information or other signal lines depending on the mode. Settings of register 644 can indicate configuration for I/O settings (e.g., timing, termination or ODT (on-die termination) 646, driver configuration, or other I/O settings).

In one example, memory device 640 includes ODT 646 as part of the interface hardware associated with I/O 642. ODT 646 can be configured as mentioned above, and provide settings for impedance to be applied to the interface to specified signal lines. In one example, ODT 646 is applied to DQ signal lines. In one example, ODT 646 is applied to command signal lines. In one example, ODT 646 is applied to address signal lines. In one example, ODT 646 can be applied to any combination of the preceding. The ODT settings can be changed based on whether a memory device is a selected target of an access operation or a non-target device. ODT 646 settings can affect the timing and reflections of signaling on the terminated lines. Careful control over ODT 646 can enable higher-speed operation with improved matching of applied impedance and loading. ODT 646 can be applied to specific signal lines of I/O interface 642, 622 (for example, ODT for DQ lines or ODT for CA lines), and is not necessarily applied to all signal lines.

Memory device 640 includes controller 650, which represents control logic within the memory device to control internal operations within the memory device. For example, controller 650 decodes commands sent by memory controller 620 and generates internal operations to execute or satisfy the commands. Controller 650 can be referred to as an internal controller, and is separate from memory controller 620 of the host. Controller 650 can determine what mode is selected based on register 644, and configure the internal execution of operations for access to memory resources 660 or other operations based on the selected mode. Controller 650 generates control signals to control the routing of bits within memory device 640 to provide a proper interface for the selected mode and direct a command to the proper memory locations or addresses. Controller 650 includes command logic 652, which can decode command encoding received on command and address signal lines. Thus, command logic 652 can be or include a command decoder. With command logic 652, memory device can identify commands and generate internal operations to execute requested commands.

Referring again to memory controller 620, memory controller 620 includes command (CMD) logic 624, which represents logic or circuitry to generate commands to send to memory devices 640. The generation of the commands can refer to the command prior to scheduling, or the preparation of queued commands ready to be sent. Generally, the signaling in memory subsystems includes address information within or accompanying the command to indicate or select one or more memory locations where the memory devices should execute the command. In response to scheduling of transactions for memory device 640, memory controller 620 can issue commands via I/O 622 to cause memory device 640 to execute the commands. In one example, controller 650 of memory device 640 receives and decodes command and address information received via I/O 642 from memory controller 620. Based on the received command and address information, controller 650 can control the timing of operations of the logic and circuitry within memory device 640 to execute the commands. Controller 650 is responsible for compliance with standards or specifications within memory device 640, such as timing and signaling requirements. Memory controller 620 can implement compliance with standards or specifications by access scheduling and control.

Memory controller 620 includes scheduler 630, which represents logic or circuitry to generate and order transactions to send to memory device 640. From one perspective, the primary function of memory controller 620 could be said to schedule memory access and other transactions to memory device 640. Such scheduling can include generating the transactions themselves to implement the requests for data by processor 610 and to maintain integrity of the data (e.g., such as with commands related to refresh). Transactions can include one or more commands, and result in the transfer of commands or data or both over one or multiple timing cycles such as clock cycles or unit intervals. Transactions can be for access such as read or write or related commands or a combination, and other transactions can include memory management commands for configuration, settings, data integrity, or other commands or a combination.

Memory controller 620 typically includes logic such as scheduler 630 to allow selection and ordering of transactions to improve performance of system 600. Thus, memory controller 620 can select which of the outstanding transactions should be sent to memory device 640 in which order, which is typically achieved with logic much more complex that a simple first-in first-out algorithm. Memory controller 620 manages the transmission of the transactions to memory device 640, and manages the timing associated with the transaction. In one example, transactions have deterministic timing, which can be managed by memory controller 620 and used in determining how to schedule the transactions with scheduler 630.

In one example, memory controller 620 includes refresh (REF) logic 626. Refresh logic 626 can be used for memory resources that are volatile and need to be refreshed to retain a deterministic state. In one example, refresh logic 626 indicates a location for refresh, and a type of refresh to perform. Refresh logic 626 can trigger self-refresh within memory device 640, or execute external refreshes which can be referred to as auto refresh commands) by sending refresh commands, or a combination. In one example, controller 650 within memory device 640 includes refresh logic 654 to apply refresh within memory device 640. In one example, refresh logic 654 generates internal operations to perform refresh in accordance with an external refresh received from memory controller 620. Refresh logic 654 can determine if a refresh is directed to memory device 640, and what memory resources 660 to refresh in response to the command.

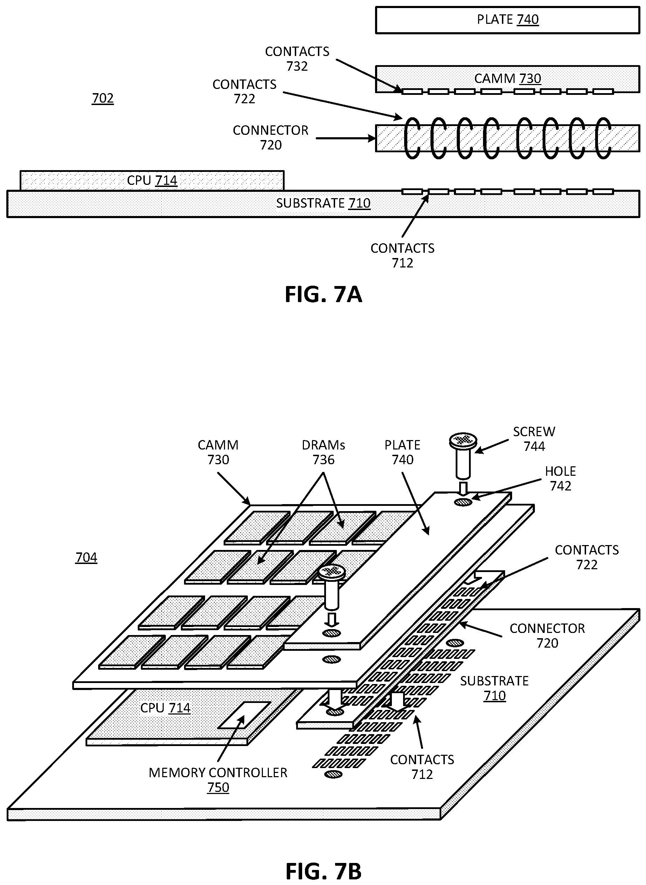

**Figures 7A-7B** are block diagrams of an example of a CAMM system in which runtime memory IO margining can be implemented.

Referring to **Figure 7A****,** system 702 includes a memory stack architecture. System 702 represents a system with a memory subsystem in accordance with an example of system 100 or an example of system 200. In one example, the DRAMs of CAMM 730 can perform internal parameter sweeps, in accordance with any example herein.

Substrate 710 illustrates an SOC package substrate or a motherboard or system board. Substrate 710 includes contacts 712, which represent contacts for connecting with memory. CPU 714 represents a processor or central processing unit (CPU) chip or graphics processing unit (GPU) chip to be disposed on substrate 710. CPU 714 performs the computational operations in system 702. In one example, CPU 714 includes multiple cores (not specifically shown), which can generate operations that request data to be read from and written to memory. CPU 714 can include a memory controller to manage access to the memory devices.

Compression-attached memory module (CAMM) 730 represents a module with memory devices, which are not specifically illustrated in system 702. Substrate 710 couples to CAMM 730 and its memory devices through compression mount technology (CMT) connector 720. Connector 720 includes contacts 722, which are compression-based contacts. The compression-based contacts are compressible pins or devices whose shape compresses with the application of pressure on connector 720. In one example, contacts 722 represent C-shaped pins as illustrated. In one example, contacts 722 represent another compressible pin shape, such as a spring-shape, an S-shape, or pins having other shapes that can be compressed.

CAMM 730 includes contacts 732 on a side of the CAMM board that interfaces with connector 720. Contacts 732 connect to memory devices on the CAMM board. Plate 740 represents a plate or housing that provides structure to apply pressure to compress contacts 722 of connector 720.

Referring to **Figure 7B****,** system 704 is a perspective view of a system in accordance with system 702. CAMM 730 is illustrated with memory chips or memory dies, identified as DRAMs 736 on one or both faces of the PCB of CAMM 730. DRAMs 736 are coupled with conductive contacts via conductive traces in or on the PCB, which couples with contacts 732, which in turn couple with contacts 722 of connector 720.

System 704 illustrates holes 742 in plate 740 to receive fasteners, represented by screws 744. There are corresponding holes through CAMM 730, connector 720, and in substrate 710. Screws 744 can compressibly attach the CAMM 730 to substrate 710 via connector 720.

System 704 illustrates memory controller 750, which is not specifically illustrated in system 702. System 704 represents a system with a memory subsystem in accordance with an example of system 100 or an example of system 200. In one example, DRAMs 736 are organized as ranks that have a reserved memory space, which represents a reserved memory space for margining data. Memory controller 750 can include configuration to select between functional IO configuration settings and margining IO configuration settings. System 704 can perform runtime IO margining for timing settings, voltage settings, or both timing and voltage settings, in accordance with any example herein.

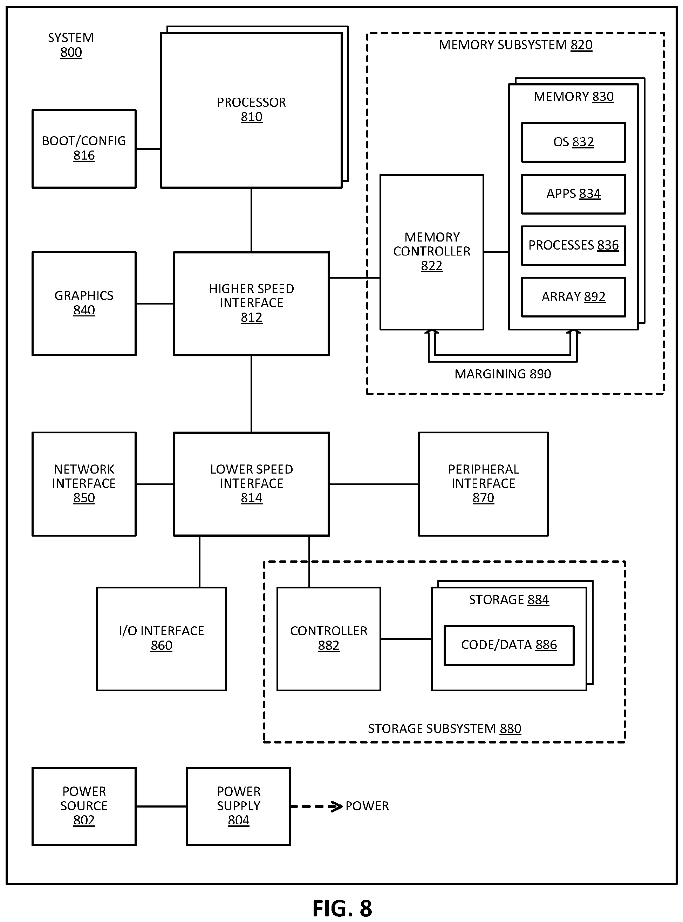

**Figure 8** is a block diagram of an example of a computing system in which runtime memory IO margining can be implemented. System 800 represents a computing device in accordance with any example herein, and can be a laptop computer, a desktop computer, a tablet computer, a server, a gaming or entertainment control system, embedded computing device, or other electronic device.

System 800 represents a system with a memory subsystem in accordance with an example of system 100 or an example of system 200. In one example, memory 830 is organized as ranks that have a reserved memory space, which represents a reserved memory space for margining data. Array 892 represents the memory array with reserved memory space. Memory controller 822 can include configuration to select between functional IO configuration settings and margining IO configuration settings. Margining 890 represents the ability of system 800 to perform runtime IO margining for timing settings, voltage settings, or both timing and voltage settings, in accordance with any example herein.

System 800 includes processor 810 can include any type of microprocessor, central processing unit (CPU), graphics processing unit (GPU), processing core, or other processing hardware, or a combination, to provide processing or execution of instructions for system 800. Processor 810 can be a host processor device. Processor 810 controls the overall operation of system 800, and can be or include, one or more programmable general-purpose or special-purpose microprocessors, digital signal processors (DSPs), programmable controllers, application specific integrated circuits (ASICs), programmable logic devices (PLDs), or a combination of such devices.

System 800 includes boot/config 816, which represents storage to store boot code (e.g., basic input/output system (BIOS)), configuration settings, security hardware (e.g., trusted platform module (TPM)), or other system level hardware that operates outside of a host OS. Boot/config 816 can include a nonvolatile storage device, such as read-only memory (ROM), flash memory, or other memory devices.

In one example, system 800 includes interface 812 coupled to processor 810, which can represent a higher speed interface or a high throughput interface for system components that need higher bandwidth connections, such as memory subsystem 820 or graphics interface components 840. Interface 812 represents an interface circuit, which can be a standalone component or integrated onto a processor die. Interface 812 can be integrated as a circuit onto the processor die or integrated as a component on a system on a chip. Where present, graphics interface 840 interfaces to graphics components for providing a visual display to a user of system 800. Graphics interface 840 can be a standalone component or integrated onto the processor die or system on a chip. In one example, graphics interface 840 can drive a high definition (HD) display or ultra high definition (UHD) display that provides an output to a user. In one example, the display can include a touchscreen display. In one example, graphics interface 840 generates a display based on data stored in memory 830 or based on operations executed by processor 810 or both.

Memory subsystem 820 represents the main memory of system 800, and provides storage for code to be executed by processor 810, or data values to be used in executing a routine. Memory subsystem 820 can include one or more varieties of random-access memory (RAM) such as DRAM, 3DXP (three-dimensional crosspoint), or other memory devices, or a combination of such devices. Memory 830 stores and hosts, among other things, operating system (OS) 832 to provide a software platform for execution of instructions in system 800. Additionally, applications 834 can execute on the software platform of OS 832 from memory 830. Applications 834 represent programs that have their own operational logic to perform execution of one or more functions. Processes 836 represent agents or routines that provide auxiliary functions to OS 832 or one or more applications 834 or a combination. OS 832, applications 834, and processes 836 provide software logic to provide functions for system 800. In one example, memory subsystem 820 includes memory controller 822, which is a memory controller to generate and issue commands to memory 830. It will be understood that memory controller 822 could be a physical part of processor 810 or a physical part of interface 812. For example, memory controller 822 can be an integrated memory controller, integrated onto a circuit with processor 810, such as integrated onto the processor die or a system on a chip.

While not specifically illustrated, it will be understood that system 800 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 800 includes interface 814, which can be coupled to interface 812. Interface 814 can be a lower speed interface than interface 812. In one example, interface 814 represents an interface circuit, which can include standalone components and integrated circuitry. In one example, multiple user interface components or peripheral components, or both, couple to interface 814. Network interface 850 provides system 800 the ability to communicate with remote devices (e.g., servers or other computing devices) over one or more networks. Network interface 860 can represent a network interface circuit (NIC) that enables connection with a remote device over a network connection. The network connection enabled by network interface 850 can include an Ethernet adapter, wireless interconnection components, cellular network interconnection components, USB (universal serial bus), or other wired or wireless standards-based or proprietary interfaces. Network interface 850 can exchange data with a remote device, which can include sending data stored in memory or receiving data to be stored in memory.

In one example, system 800 includes one or more input/output (I/O) interface(s) 860. I/O interface 860 can include one or more interface components through which a user interacts with system 800 (e.g., audio, alphanumeric, tactile/touch, or other interfacing). Peripheral interface 870 can include any hardware interface not specifically mentioned above. Peripherals refer generally to devices that connect dependently to system 800. A dependent connection is one where system 800 provides the software platform or hardware platform or both on which operation executes, and with which a user interacts.

In one example, system 800 includes storage subsystem 880 to store data in a nonvolatile manner. In one example, in certain system implementations, at least certain components of storage 880 can overlap with components of memory subsystem 820. Storage subsystem 880 includes storage device(s) 884, which can be or include any conventional medium for storing large amounts of data in a nonvolatile manner, such as one or more magnetic, solid state, NAND, 3DXP, or optical based disks, or a combination. Storage 884 holds code or instructions and data 886 in a persistent state (i.e., the value is retained despite interruption of power to system 800). Storage 884 can be generically considered to be a "memory," although memory 830 is typically the executing or operating memory to provide instructions to processor 810. Whereas storage 884 is nonvolatile, memory 830 can include volatile memory (i.e., the value or state of the data is indeterminate if power is interrupted to system 800). In one example, storage subsystem 880 includes controller 882 to interface with storage 884. In one example controller 882 is a physical part of interface 814 or processor 810, or can include circuits or logic in both processor 810 and interface 814.

Power source 802 provides power to the components of system 800. More specifically, power source 802 typically interfaces to one or multiple power supplies 804 in system 800 to provide power to the components of system 800. In one example, power supply 804 includes an AC to DC (alternating current to direct current) adapter to plug into a wall outlet. Such AC power can be renewable energy (e.g., solar power) power source 802. In one example, power source 802 includes a DC power source, such as an external AC to DC converter. In one example, power source 802 or power supply 804 includes wireless charging hardware to charge via proximity to a charging field. In one example, power source 802 can include an internal battery or fuel cell source.

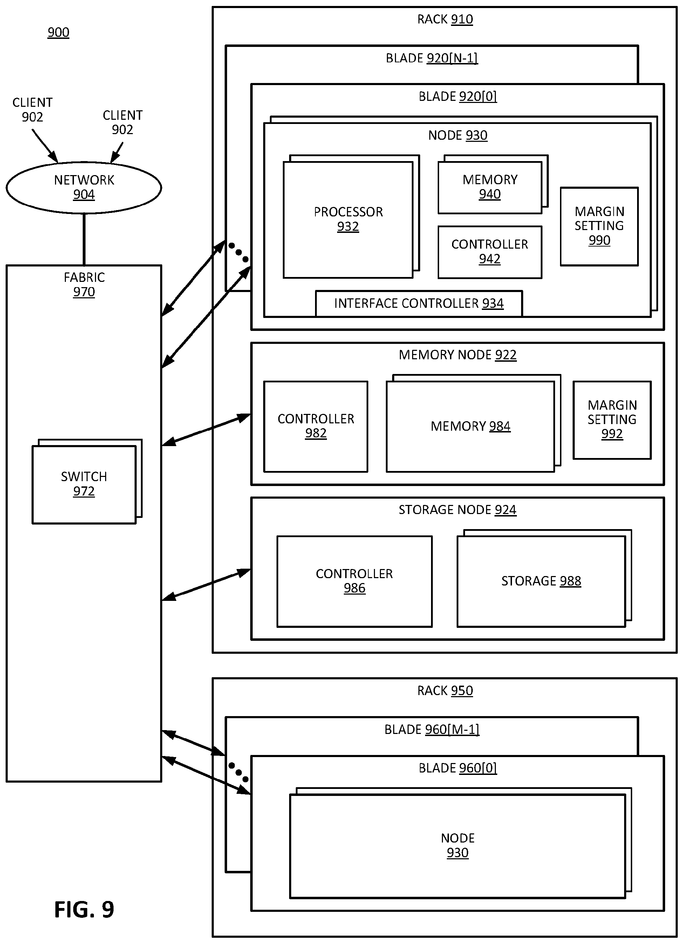

**Figure 9** is a block diagram of an example of a multi-node network in which runtime memory IO margining can be implemented. System 900 represents a network of nodes that can apply adaptive ECC. In one example, system 900 represents a data center. In one example, system 900 represents a server farm. In one example, system 900 represents a data cloud or a processing cloud.

In one example, node 930 represents a system with a memory subsystem in accordance with an example of system 100 or an example of system 200. In one example, memory 940 is organized as ranks that have a reserved memory space, which represents a reserved memory space for margining data. Controller 942 can include configuration to select between functional IO configuration settings and margining IO configuration settings. Margin setting 990 represents the ability of system 900 to perform runtime IO margining for timing settings, voltage settings, or both timing and voltage settings, for node 930 in accordance with any example herein. Margin setting 992 represents the ability of system 900 to perform runtime IO margining for timing settings, voltage settings, or both timing and voltage settings, for memory node 922 in accordance with any example herein.

One or more clients 902 make requests over network 904 to system 900. Network 904 represents one or more local networks, or wide area networks, or a combination. Clients 902 can be human or machine clients, which generate requests for the execution of operations by system 900. System 900 executes applications or data computation tasks requested by clients 902.

In one example, system 900 includes one or more racks, which represent structural and interconnect resources to house and interconnect multiple computation nodes. In one example, rack 910 includes multiple nodes 930. In one example, rack 910 hosts multiple blade components, blade 920[0], ..., blade 920[N-1], collectively blades 920. Hosting refers to providing power, structural or mechanical support, and interconnection. Blades 920 can refer to computing resources on printed circuit boards (PCBs), where a PCB houses the hardware components for one or more nodes 930. In one example, blades 920 do not include a chassis or housing or other "box" other than that provided by rack 910. In one example, blades 920 include housing with exposed connector to connect into rack 910. In one example, system 900 does not include rack 910, and each blade 920 includes a chassis or housing that can stack or otherwise reside in close proximity to other blades and allow interconnection of nodes 930.

System 900 includes fabric 970, which represents one or more interconnectors for nodes 930. In one example, fabric 970 includes multiple switches 972 or routers or other hardware to route signals among nodes 930. Additionally, fabric 970 can couple system 900 to network 904 for access by clients 902. In addition to routing equipment, fabric 970 can be considered to include the cables or ports or other hardware equipment to couple nodes 930 together. In one example, fabric 970 has one or more associated protocols to manage the routing of signals through system 900. In one example, the protocol or protocols is at least partly dependent on the hardware equipment used in system 900.

As illustrated, rack 910 includes N blades 920. In one example, in addition to rack 910, system 900 includes rack 950. As illustrated, rack 950 includes M blade components, blade 960[0], ..., blade 960[M-1], collectively blades 960. M is not necessarily the same as N; thus, it will be understood that various different hardware equipment components could be used, and coupled together into system 900 over fabric 970. Blades 960 can be the same or similar to blades 920. Nodes 930 can be any type of node and are not necessarily all the same type of node. System 900 is not limited to being homogenous, nor is it limited to not being homogenous.

The nodes in system 900 can include compute nodes, memory nodes, storage nodes, accelerator nodes, or other nodes. Rack 910 is represented with memory node 922 and storage node 924, which represent shared system memory resources, and shared persistent storage, respectively. One or more nodes of rack 950 can be a memory node or a storage node.

Nodes 930 represent examples of compute nodes. For simplicity, only the compute node in blade 920[0] is illustrated in detail. However, other nodes in system 900 can be the same or similar. At least some nodes 930 are computation nodes, with processor (proc) 932 and memory 940. A computation node refers to a node with processing resources (e.g., one or more processors) that executes an operating system and can receive and process one or more tasks. In one example, at least some nodes 930 are server nodes with a server as processing resources represented by processor 932 and memory 940.

Memory node 922 represents an example of a memory node, with system memory external to the compute nodes. Memory nodes can include controller 982, which represents a processor on the node to manage access to the memory. The memory nodes include memory 984 as memory resources to be shared among multiple compute nodes.

Storage node 924 represents an example of a storage server, which refers to a node with more storage resources than a computation node, and rather than having processors for the execution of tasks, a storage server includes processing resources to manage access to the storage nodes within the storage server. Storage nodes can include controller 986 to manage access to the storage 988 of the storage node.

In one example, node 930 includes interface controller 934, which represents logic to control access by node 930 to fabric 970. The logic can include hardware resources to interconnect to the physical interconnection hardware. The logic can include software or firmware logic to manage the interconnection. In one example, interface controller 934 is or includes a host fabric interface, which can be a fabric interface in accordance with any example described herein. The interface controllers for memory node 922 and storage node 924 are not explicitly shown.

Processor 932 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory 940 can be or include memory devices represented by memory 940 and a memory controller represented by controller 942.

In general with respect to the descriptions herein, in one aspect, a memory module includes: a rank of memory having multiple dynamic random access memory (DRAM) devices; and a physical interface having: an interface to a data bus, selectable between a runtime input/output (IO) configuration and a margining IO configuration; and a rank bit to trigger access to a reserved space of the rank of memory; wherein, in response to assertion of the rank bit, the interface to the data bus is configured with the margining IO configuration, and the rank of memory is to write data from the data bus into the reserved space.

In one example of the memory module, the data bus is to switch during runtime to carry runtime traffic when the interface to the data bus is configured with the runtime IO configuration, and to carry margining traffic when the interface to the data bus is configured with the margining IO configuration. In accordance with any preceding example of the memory module, in one example, in response to a data error rate for margining data written to the reserved space with the interface to the data bus configured with the margining IO configuration, the margining IO configuration is to become the runtime IO configuration. In accordance with any preceding example of the memory module, in one example, the margining IO configuration has at least one delay timing different than the runtime IO configuration. In accordance with any preceding example of the memory module, in one example, the margining IO configuration has at least one voltage setting different than the runtime IO configuration.

In general with respect to the descriptions herein, in one aspect, a memory controller includes: a physical interface to couple to multiple memory modules, the multiple memory modules having multiple dynamic random access memory (DRAM) devices organized as multiple ranks of memory, including a first rank and a second rank, the physical interface including: an interface to a first data bus to couple to the first rank, the interface to the first data bus selectable between a first runtime input/output (IO) configuration and a first margining IO configuration; a first rank bit to trigger access to a reserved space of the first rank; an interface to a second data bus to couple to the second rank, the interface to the second data bus selectable between a second runtime input/output (IO) configuration and a second margining IO configuration; and a second rank bit to trigger access to a reserved space of the second rank; wherein the physical interface is to selectively set the interface to the first data bus to the first margining IO configuration, set the first rank bit, and write margining data to the reserved space of the first rank.

In one example of the memory controller, the first data bus is to switch during runtime to carry runtime traffic when the interface to the first data bus is configured with the first runtime IO configuration, and to carry margining traffic when the interface to the first data bus is configured with the first margining IO configuration, wherein in response to a data error rate for margining data written to the reserved space of the first rank with the interface to the first data bus configured with the first margining IO configuration, the memory controller is to set the first margining IO configuration as the first runtime IO configuration. In accordance with any preceding example of the memory controller, in one example, the second data bus is to switch during runtime to carry runtime traffic when the interface to the second data bus is configured with the second runtime IO configuration, and to carry margining traffic when the interface to the second data bus is configured with the second margining IO configuration, wherein in response to a data error rate for margining data written to the reserved space of the second rank with the interface to the second data bus configured with the second margining IO configuration, the memory controller is to set the second margining IO configuration as the second runtime IO configuration. In accordance with any preceding example of the memory controller, in one example, the first margining IO configuration has at least one delay timing different than the first runtime IO configuration and the second margining IO configuration has at least one delay timing different than the second runtime IO configuration. In accordance with any preceding example of the memory controller, in one example, the first margining IO configuration has at least one voltage setting different than the first runtime IO configuration and the second margining IO configuration has at least one voltage setting different than the second runtime IO configuration. In accordance with any preceding example of the memory controller, in one example, the first data bus is to switch during runtime to carry runtime traffic when the interface to the first data bus is configured with the first runtime IO configuration, and to carry margining traffic when the interface to the first data bus is configured with the first margining IO configuration, wherein in response to a high bit error rate (BER) for the runtime traffic, the memory controller is to reduce a transfer speed for the runtime traffic, increase the margining traffic to determine an improved IO configuration, and apply the improved IO configuration as the first runtime IO configuration. In accordance with any preceding example of the memory controller, in one example, the first data bus is to switch during runtime to carry runtime traffic when the interface to the first data bus is configured with the first runtime IO configuration, and to carry margining traffic when the interface to the first data bus is configured with the first margining IO configuration, wherein in response to a high bit error rate (BER) for the runtime traffic, the memory controller is to turn off the runtime traffic of a memory channel of the first data bus, perform margining traffic to determine an improved IO configuration, and apply the improved IO configuration as the first runtime IO configuration. In accordance with any preceding example of the memory controller, in one example, the memory controller includes a memory address map to identify the reserved space of the first rank with the first rank bit and the reserved space of the second rank with the second rank bit.

In general with respect to the descriptions herein, in one aspect, a method for memory access, includes: setting a rank bit of a physical interface coupled to multiple memory modules, the multiple memory modules having multiple dynamic random access memory (DRAM) devices organized as a rank of memory; changing an input/output (IO) configuration of a data bus coupled to the rank of memory from a runtime IO configuration to a margining IO configuration in response to the rank bit being set; writing margining data to a reserved space of the rank of memory, only accessible when the rank bit is set; reading the margining data back from the reserved space; and comparing a performance of the margining IO configuration to the runtime IO configuration.

In one example of the method, in response to the performance of the margining IO configuration have a lower data error rate than the runtime IO configuration, setting the margining IO configuration as the runtime IO configuration. In accordance with any preceding example of the method, in one example, the margining IO configuration has at least one delay timing different than the runtime IO configuration. In accordance with any preceding example of the method, in one example, the margining IO configuration has at least one voltage setting different than the runtime IO configuration. In accordance with any preceding example of the method, in one example, in response to a high bit error rate (BER) for the runtime IO configuration, the method includes: reducing a transfer speed for traffic on the data bus; and applying the margining data to reconfigure the runtime IO configuration. In accordance with any preceding example of the method, in one example, in response to a high bit error rate (BER) for the runtime IO configuration, the method includes turning off a memory channel of the data bus for functional traffic; and applying the margining data to reconfigure the runtime IO configuration. In accordance with any preceding example of the method, in one example, writing the margining data to the reserved space of the rank of memory and reading the margining data back from the reserved space of the rank of memory comprises mixing scheduling of margining traffic to the reserved space of the rank of memory with functional traffic to the rank of memory.

In general with respect to the descriptions herein, in one aspect, a computer readable storage medium has content stored thereon, which when executed by a machine causes the machine to perform a method for memory access, including: setting a rank bit of a physical interface coupled to multiple memory modules, the multiple memory modules having multiple dynamic random access memory (DRAM) devices organized as a rank of memory; changing an input/output (IO) configuration of a data bus coupled to the rank of memory from a runtime IO configuration to a margining IO configuration in response to the rank bit being set; writing margining data to a reserved space of the rank of memory, only accessible when the rank bit is set; reading the margining data back from the reserved space; and comparing a performance of the margining IO configuration to the runtime IO configuration.

In one example of the computer readable storage medium, in response to the performance of the margining IO configuration have a lower data error rate than the runtime IO configuration, setting the margining IO configuration as the runtime IO configuration. In accordance with any preceding example of the computer readable storage medium, in one example, the margining IO configuration has at least one delay timing different than the runtime IO configuration. In accordance with any preceding example of the computer readable storage medium, in one example, the margining IO configuration has at least one voltage setting different than the runtime IO configuration. In accordance with any preceding example of the computer readable storage medium, in one example, in response to a high bit error rate (BER) for the runtime IO configuration, the method includes: reducing a transfer speed for traffic on the data bus; and applying the margining data to reconfigure the runtime IO configuration. In accordance with any preceding example of the computer readable storage medium, in one example, in response to a high bit error rate (BER) for the runtime IO configuration, the method includes turning off a memory channel of the data bus for functional traffic; and applying the margining data to reconfigure the runtime IO configuration. In accordance with any preceding example of the computer readable storage medium, in one example, writing the margining data to the reserved space of the rank of memory and reading the margining data back from the reserved space of the rank of memory comprises mixing scheduling of margining traffic to the reserved space of the rank of memory with functional traffic to the rank of memory.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A method for memory access, comprising:
setting a rank bit of a physical interface coupled to multiple memory modules, the multiple memory modules having multiple dynamic random access memory (DRAM) devices organized as a rank of memory;
changing an input/output (IO) configuration of a data bus coupled to the rank of memory from a runtime IO configuration to a margining IO configuration in response to the rank bit being set;
writing margining data to a reserved space of the rank of memory, only accessible when the rank bit is set;
reading the margining data back from the reserved space; and
comparing a performance of the margining IO configuration to the runtime IO configuration.

2. The method of claim 1, wherein in response to the performance of the margining IO configuration have a lower data error rate than the runtime IO configuration, setting the margining IO configuration as the runtime IO configuration.

3. The method of either claim 1 or 2, wherein the margining IO configuration has at least one delay timing different than the runtime IO configuration.

4. The method of any of claims 1 to 3, wherein the margining IO configuration has at least one voltage setting different than the runtime IO configuration.

5. The method of any of claims 1 to 4, wherein in response to a high bit error rate (BER) for the runtime IO configuration, the method includes:
reducing a transfer speed for traffic on the data bus; and
applying the margining data to reconfigure the runtime IO configuration.

6. The method of any of claims 1 to 5, wherein in response to a high bit error rate (BER) for the runtime IO configuration, the method includes:
turning off a memory channel of the data bus for functional traffic; and
applying the margining data to reconfigure the runtime IO configuration.

7. The method of any of claims 1 to 6, wherein writing the margining data to the reserved space of the rank of memory and reading the margining data back from the reserved space of the rank of memory comprises mixing scheduling of margining traffic to the reserved space of the rank of memory with functional traffic to the rank of memory.

8. A memory module comprising:
a rank of memory having multiple dynamic random access memory (DRAM) devices; and
a physical interface having:
an interface to a data bus, selectable between a runtime input/output (IO) configuration and a margining IO configuration; and
a rank bit to trigger access to a reserved space of the rank of memory;
wherein, in response to assertion of the rank bit, the interface to the data bus is configured with the margining IO configuration, and the rank of memory is to write data from the data bus into the reserved space.

9. The memory module of claim 8, wherein the data bus is to switch during runtime to carry runtime traffic when the interface to the data bus is configured with the runtime IO configuration, and to carry margining traffic when the interface to the data bus is configured with the margining IO configuration.

10. The memory module of either of claims 8 or 9, wherein in response to a data error rate for margining data written to the reserved space with the interface to the data bus configured with the margining IO configuration, the margining IO configuration is to become the runtime IO configuration.

11. The memory module of any of claims 8 to 10, wherein the margining IO configuration has at least one delay timing different than the runtime IO configuration or least one voltage setting different than the runtime IO configuration.

12. A memory controller comprising:
a physical interface to couple to multiple memory modules, the multiple memory modules having multiple dynamic random access memory (DRAM) devices organized as multiple ranks of memory, including a first rank and a second rank, the physical interface including:
an interface to a first data bus to couple to the first rank, the interface to the first data bus selectable between a first runtime input/output (IO) configuration and a first margining IO configuration;
a first rank bit to trigger access to a reserved space of the first rank;
an interface to a second data bus to couple to the second rank, the interface to the second data bus selectable between a second runtime input/output (IO) configuration and a second margining IO configuration; and
a second rank bit to trigger access to a reserved space of the second rank;
wherein the physical interface is to selectively set the interface to the first data bus to the first margining IO configuration, set the first rank bit, and write margining data to the reserved space of the first rank.

13. The memory controller of claim 12, wherein the first data bus is to switch during runtime to carry runtime traffic when the interface to the first data bus is configured with the first runtime IO configuration, and to carry margining traffic when the interface to the first data bus is configured with the first margining IO configuration, wherein in response to a data error rate for margining data written to the reserved space of the first rank with the interface to the first data bus configured with the first margining IO configuration, the memory controller is to set the first margining IO configuration as the first runtime IO configuration.

14. The memory controller of claim 12, wherein the second data bus is to switch during runtime to carry runtime traffic when the interface to the second data bus is configured with the second runtime IO configuration, and to carry margining traffic when the interface to the second data bus is configured with the second margining IO configuration, wherein in response to a data error rate for margining data written to the reserved space of the second rank with the interface to the second data bus configured with the second margining IO configuration, the memory controller is to set the second margining IO configuration as the second runtime IO configuration.

15. The memory controller of any of claim 12 to 14, wherein the first margining IO configuration has at least one delay timing different than the first runtime IO configuration and the second margining IO configuration has at least one delay timing different than the second runtime IO configuration or wherein the first margining IO configuration has at least one voltage setting different than the first runtime IO configuration and the second margining IO configuration has at least one voltage setting different than the second runtime IO configuration.
